# EUROPÄISCHE PATENTANMELDUNG

(11) **EP 4 354 732 A1**
(43) Veröffentlichungstag der Anmeldung: **17.04.2024**
(21) Anmeldenummer: 23197107.8
(22) Anmeldetag: 13.09.2023
(51) Int. Cl.: H03K 17/06

(54) **VERFAHREN UND VORRICHTUNG ZUM BETRIEB EINES LEISTUNGSHALBLEITERELEMENTS**

(30) Priorität: 10.10.2022 DE 102022210647
(71) Anmelder: VOLKSWAGEN AG, 38440 Wolfsburg (DE)
(72) Erfinder: Arnaout, Samy, 34305 Niedenstein (DE); Kertes, Marko, 13187 Berlin (DE)

(57) **Zusammenfassung**

Die Erfindung betrifft ein Verfahren und Vorrichtung zum Betrieb eines Leistungshalbleiterelements mit einem einstellbaren Durchgangswiderstand für einen Leistungsstrom, wobei eine Steuergröße (SGmin) zur Einstellung des minimalen Durchgangswiderstands verändert wird, wobei die Steuergröße (SGmin) zur Einstellung des minimalen Durchgangswiderstands für eine vorbestimmte Zeitdauer auf einen Zielwert (ZW) eingestellt wird, der von einem empfohlenen Wert (SGmin_r) zur Einstellung eines empfohlenen minimalen Durchgangswiderstands abweicht und zu einer Verringerung des minimalen Durchgangswiderstands im Vergleich zu dem empfohlenen Durchgangswiderstand führt, wobei die Steuergröße (SGmin) für eine vorbestimmte Zeitdauer (Tf) auf den Zielwert (ZW) eingestellt wird, wobei die vorbestimmte Zeitdauer (Tf) fest parametrisiert ist.

## Beschreibung

Die Erfindung betrifft ein Verfahren und Vorrichtung zum Betrieb eines Leistungshalbleiterelements.

In Elektro- oder Hybridfahrzeugen, aber auch in anderen Anwendungen, werden Leistungshalbleiterelemente verwendet. Diese können z.B. Bestandteil eines Pulswechselrichters (PWR) sein, der eine der Schlüsselkomponenten der E-Mobilität ist. Die Optimierung dieser Komponente wirkt sich positiv auf den gesamten Antriebsstrang aus und führt damit zu einem echten Mehrwert für den Endverbraucher. Eine Kommutierungszelle eines PWR besteht aus einem Zwischenkreis und mindestens einer Halbbrücke Optimierungen können dabei sowohl mechanisch, z.B. am Layout der Halbbrücke, der Anbindung an den Zwischenkreis, als auch elektrisch, z.B. durch Optimierung des Gate-Treiber-Kreises oder der Optimierung der Halbleitercharakteristik vorgenommen werden. In einem Elektro- oder Hybridfahrzeug kann der PWR Teil eines Traktionsnetzes sein und zur Bereitstellung einer Wechselspannung für eine elektrische Antriebsmaschine dienen.

Beispielhaft können Leistungshalbleiterelemente als Siliziumkarbid MOSFETs ausgebildet sein. Empfohlene Gate-Spannungen (recommended gate voltage) solcher MOSFET zur Einstellung eines maximalen oder minimalen Durchgangswiderstands werden normalerweise vom Halbleiterhersteller angegeben. Z. B. liegen empfohlenen Werte für die Einstellung eines minimalen Durchgangswiderstands je Hersteller zwischen 15V und 18V. Normalerweise wird der empfohlene Wert während des Betriebs konstant gehalten. Die Chip-Fläche eines Leistungshalbleiterelements wird oft bezogen auf den höchst auftretenden Strom im Antrieb ausgelegt, der beispielsweise bei einem kurzzeitigen Boostbetrieb mit einer Zeitdauer von 5-20 Sekunden bei einer hohen Kühlmittel- und Umgebungstemperatur auftreten kann. Auch kann der aktive Kurzschlussfall der Antriebsmaschine als Design-Kriterium gewählt, weil hier die höchsten Ströme auftreten.

Die US 2011/007536 A1 betrifft eine Vorrichtung zum Ansteuern eines Wechselrichters und insbesondere die Unterdrückung von Stoßspannungen und die Verringerung von stationären Verlusten.

Die US 2019/0149145 A1 offenbart einen Gate-Treiber für einen Festkörperschalter eines Fahrzeugleistungsmoduls, bei dem ein variabler Widerstand zwischen einen Spiegelschalter-Emitter und einen Lastschalter-Emitter gekoppelt ist.

Die US 10,505,538 B1 offenbart Schaltkreistopologien und zugehörige Steuerverfahren zur Verwendung in einem System, wenn eine angetriebene Last mit Energie versorgt wird, z. B. eine mehrphasige elektrische Maschine oder eine ohmsche Last. Insbesondere werden ein dynamisches Gate-Ansteuersystem und ein Steuerverfahren offenbart, die zusammen Beschränkungen bestimmter Schaltungstopologien angehen, die auf die Worst-Case-Dimensionierung des Gate-Widerstands zugeschnitten sind.

Die WO 2021/047768 A1 offenbart Leistungshalbleiterschalter wie IGBTs und insbesondere das Reduzieren der thermischen Belastung eines Leistungshalbleiterschalters.

Die US 2009/0001915 A1 betrifft die Steuerung von elektrischen Antrieben, insbesondere Verfahren und Vorrichtungen zur Spannungskontrolle von elektrischen Motoren.

Es stellt sich das technische Problem, ein Verfahren und eine Vorrichtung zum Betrieb eines Leistungshalbleiterelements zu schaffen, die einen Anwendungsbereich des Leistungshalbleiterelements ohne Bauraumveränderung, insbesondere -vergrößerung, des Leistungshalbleiterelements vergrößern.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird ein Verfahren zum Betrieb eines Leistungshalbleiterelements mit einem einstellbaren Durchgangswiderstand für einen Leistungsstrom. Das Leistungshalbleiterelement kann ein Feldeffekttransistor oder ein Thyristor sein. Z.B. kann ein Leistungshalbleiterelement ein MOSFET, insbesondere ein SI-MOSFET oder ein GaN-MOSFET, ein IBGT, ein IGCT oder ein weiteres Leistungshalbleiterelement sein.

Das Leistungshalbleiterelement kann Bestandteil eines Stromrichters, insbesondere eines Wechsel- oder Gleichrichters, sein, insbesondere Bestandteil eines ein- oder mehrphasigen, insbesondere dreiphasigen, Wechselrichters. Der Stromrichter kann wiederum Bestandteil eines elektrischen Netzwerks sein, insbesondere eines Traktionsnetzes eines Fahrzeugs, z.B. eines Elektro- oder Hybridfahrzeugs. Das Traktionsnetz kann zusätzlich zum Stromrichter bzw. Leistungshalbleiterelement eine Energiespeichereinrichtung, insbesondere eine Traktionsbatterie, eine Antriebsmaschine, insbesondere eine elektrische Antriebsmaschine, und/oder einen Zwischenkreiskondensator umfassen. Somit wird auch ein Stromrichter, ein Traktionsnetz und ein Fahrzeug mit einem Leistungshalbleiterelement oder mehreren Leistungshalbleiterelementen gemäß einer der in dieser Offenbarung beschriebenen Ausführungsformen beschrieben.

In dem Verfahren wird eine Steuergröße zur Einstellung eines minimalen Durchgangswiderstands verändert. Zum Ein- und Ausschalten des Leistungshalbleiterelements kann die Steuergröße zwischen einem empfohlenen Minimalwert und einem empfohlenen Maximalwert verändert werden, wobei das Leistungshalbleiterelement in einen eingeschalteten und somit einen Leistungsstrom leitenden Zustand versetzt wird, wenn die Steuergröße auf den empfohlenen Minimalwert oder den empfohlenen Maximalwert eingestellt wird. Das Leistungshalbleiterelement wird konsequenterweise in einen ausgeschalteten und somit den Leistungsstrom nicht-leitenden Zustand versetzt, wenn die Steuergröße auf den verbleibenden der beiden empfohlenen Werte eingestellt wird. Der empfohlenen Minimalwert und der empfohlene Maximalwert können fest vorgegebene, leistungshalbleiterelementspezifische Werte sein. Diese können z.B. vom Hersteller des Leistungshalbleiterelements vorgegeben sein. Somit ist einer der empfohlenen Werte dem leitenden Zustand zugeordnet. Der minimale Durchgangswiderstand bezeichnet hierbei den Widerstand im leitenden, also eingeschalteten, Zustand und kann auch als so genannter Rds_on bezeichnet werden. Die Steuergröße kann eine Spannung oder ein Strom sein, z.B. eine Gate-Spannung.

Im Falle eines MOSFET ist die Steuergröße eine Gate-Spannung, wobei der MOSFET in einen leitenden Zustand mit dem minimalen Durchgangswiderstand versetzt wird, wenn die Gate-Spannung auf einen empfohlenen Maximalwert, z.B. +15V, eingestellt wird. Dieser Wert wird üblicherweise auch als Vgs, max oder recommended Vgs bezeichnet. Der MOSFET kann in einen nicht-leitenden Zustand mit dem maximalen Durchgangswiderstand versetzt werden, wenn die Gate-Spannung auf einen empfohlenen Minimalwert, z.B. -4V, eingestellt wird. Weiter wird die Steuergröße zur Einstellung des minimalen Durchgangswiderstands für eine vorbestimmte Zeitdauer auf einen Zielwert eingestellt wird, der von einem empfohlenen Wert zur Einstellung eines empfohlenen minimalen Durchgangswiderstands abweicht und zu einer Verringerung des minimalen Durchgangswiderstands im Vergleich zu dem empfohlenen Durchgangswiderstand führt. Der empfohlene minimale Durchgangswiderstand bezeichnet hierbei den Durchgangswiderstand, der sich ergibt, wenn die Steuergröße auf den empfohlenen Wert zur Einstellung des minimalen Durchgangswiderstands eingestellt wird. Dieser Wert ergibt sich aus den Eigenschaften des Leistungshalbleiterelements und kann z.B. ebenfalls vom Hersteller des Leistungshalbleiterelements spezifiziert sein. Insbesondere liegt also der Zielwert außerhalb des Wertebereichs zwischen dem empfohlenen Minimalwert und dem empfohlenen Maximalwert, insbesondere derart, dass der minimale Durchgangswiderstand geringer ist als der minimale Durchgangswiderstand ist, der sich bei der Einstellung der Steuergröße auf den empfohlenen Wert ergibt, der dem leitenden Zustand zugeordnet ist. Z.B. kann bei einem MOSFET die Gate-Spannung auf einen Wert eingestellt werden, der um eine vorbestimmte Differenz, z.B. +3V, größer als der empfohlene Maximalwert ist. Mit anderen Worten ist der Zielwert in diesem Ausführungsbeispiel +18V.

Die Steuergröße kann, wie nachfolgend noch näher erläutert, von mindestens einer Einrichtung zur Bereitstellung der Steuergröße bereitgestellt werden. Diese Einrichtung wiederum kann von einer Steuereinrichtung zur Bereitstellung einer gewünschten Steuergröße gesteuert werden. Diese Steuereinrichtung kann ebenfalls mindestens ein Kriterium zur Einstellung der Steuergröße auf den Zielwert auswerten. Beispielhafte Kriterien werden nachfolgend noch erläutert.

Erfindungsgemäß wird die Steuergröße für eine vorbestimmte Zeitdauer auf den Zielwert eingestellt, wobei die vorbestimmte Zeitdauer fest parametrisiert ist. Wie nachfolgend noch näher erläutert, kann die vorbestimmte Zeitdauer im Bereich von Sekunden liegen, beispielsweise kleiner als 10 Sekunden sein. Somit wird also die Steuergröße während der vorbestimmten Zeitdauer zur Einstellung eines leitenden Zustands auf den Zielwert eingestellt. Fest parametrisiert kann insbesondere bedeuten, dass die Zeitdauer während einer Lebensdauer des Leistungshalbleiterelements nicht verändert wird. Fest parametrisiert kann aber auch bedeuten, dass die Zeitdauer während einer Lebensdauer des Leistungshalbleiterelements nur geringfügig verändert wird, beispielsweise nicht mehr als 10%. Die Veränderung kann in der Lebensdauerbetrachtung bereits berücksichtigt sein. Die Veränderung kann dabei abhängig von einer bereits geleisteten Betriebszeit sein. Die vorbestimmte Zeitdauer kann beispielsweise in einer Speichereinrichtung vor der Inbetriebnahme des Leistungshalbleiterelements gespeichert werden. Die Einstellung auf den Zielwert erfolgt insbesondere unabhängig von einer Stoßspannung des Leistungshalbleiterelements. Dies kann bedeuten, dass die Stoßspannung nicht bestimmt und/oder kein stoßspannungsabhängiges Kriterium ausgewertet wird, um zu entscheiden, ob der Zielwert eingestellt wird. Der Wert der vorbestimmten Zeitdauer kann hierbei derart festgelegt werden, dass die Gesamtdauer von Zeiträumen, in denen der Zielwert eingestellt wird, während einer vorbestimmten Lebensdauer des Leistungshalbleiterelements einen vorbestimmten Wert nicht überschreitet. Hierzu kann die Anzahl der Zeiträume, in denen der Zielwert eingestellt wird, anhand von Experten- und/oder Erfahrungswissen oder modellbasiert vorbestimmt werden.

Es ergibt sich somit in vorteilhafter Weise, dass das Leistungshalbleiterelement in begrenzten Zeiträumen mit einem im Vergleich zum Normalbetrieb verringerten minimalen Durchgangswiderstand betrieben werden kann. Hierdurch kann wiederum in vorteilhafter Weise die Erzeugung von thermischer Energie durch Widerstandsverluste bei einem Stromfluss eines Leistungsstroms durch das Leistungshalbleiterelement und somit auch eine thermische Belastung des Leistungshalbleiterelements verringert werden. Dies wiederum ermöglicht z.B. das Leistungshalbleiterelement kurzzeitig bei hohen (Halbleiter- und/oder Umgebungs)-Temperaturen zu betreiben, ohne dass eine zulässige Maximaltemperatur des Leistungshalbleiterelements überschritten wird, wobei die Temperatur des Leistungshalbleiterelements insbesondere abhängig von einer Umgebungstemperatur, einer Kühlmitteltemperatur und den Widerstandsverlusten ist. So erlaubt eine Reduktion der Widerstandsverluste z.B. eine Erhöhung der Umgebungstemperatur und/oder der Kühlmitteltemperatur, ohne dass eine zulässige Maximaltemperatur überschritten wird. Ferner wird in vorteilhafter Weise erreicht, dass ein solcher Betrieb auch ohne Vergrößerung des Bauraums des Leistungshalbleiterelements, insbesondere der benötigten Chipfläche, ermöglicht wird, da zur Reduktion des minimalen Durchgangswiderstands keine Vergrößerung des Bauraums erforderlich ist. Mit anderen Worten kann somit in vorteilhafter Weise eine Leistungsdichte des Halbleiterbauelements erhöht werden. Dies wiederum bedingt auch keine Erhöhung der Herstellungskosten. Somit erhöht sich also der Anwendungsbereich des Leistungshalbleiterelements.

Das beschriebene Verfahren kann auch Anwendung in der Industrie, der Energietechnik, der Unterhaltungselektronik, der Medizintechnik und anderen Feldern finden, insbesondere zum Betreiben eines Leistungshalbleiterelements als Bestandteil eines Stromrichters. In einem Fahrzeug können mit dem beschriebenen Verfahren in vorteilhafter Weise eine erhöhte Effizienz, geringe Verluste und somit auch eine Reichweitenverlängerung erreicht werden.

In einer weiteren Ausführungsform erfolgt die Einstellung der Steuergröße auf den Zielwert, wenn ein Sollwert des Leistungsstroms größer als ein vorbestimmter Schwellwert ist. Dieser Sollwert kann ein fest parametrisierter Schwellwert sein. Alternativ kann der Sollwert anwendungsabhängig oder betriebszustandsabhängig vorgegeben werden, z.B. von einem übergeordneten System wie z.B. einem Antriebssteuerungssystem in einem Kraftfahrzeug. Hierdurch wird in vorteilhafter Weise erreicht, dass die Erzeugung thermischer Energie bei hohen Strömen reduziert werden kann. Entsprechende Vorteile wurden vorhergehend bereits erläutert.

Die Einstellung auf den Zielwert kann weiter erfolgen, wenn alternativ, vorzugsweise aber kumulativ, eine Halbleitertemperatur, also eine Temperatur des Leistungshalbleiterelements, größer als ein vorbestimmter Schwellwert ist. Eine Halbleitertemperatur kann der Temperatur eines Kühlmittels des Leistungshalbleiterelements entsprechen. Ein vorbestimmter Schwellwert kann z.B. 65° C betragen oder größer als dieser Wert sein. Hierdurch wird in vorteilhafter Weise erreicht, dass thermische Gesamtbelastung des Leistungshalbleiterelements, die sich aus den erläuterten Widerstandsverlusten und der Halbleitertemperatur ergibt, auch bei hohen Halbleitertemperaturen einen vorbestimmten Schwellwert nicht überschreitet, da die Widerstandsverluste durch die weitere Verringerung des minimalen Durchgangswiderstands reduziert werden. Dies wiederum ermöglicht höhere Halbleitertemperaturen ohne Überschreiben des Schwellwerts.

Die Einstellung auf den Zielwert kann weiter erfolgen, wenn alternativ oder (weiter) kumulativ eine Umgebungstemperatur größer als ein vorbestimmter Schwellwert ist. Ein vorbestimmter Schwellwert kann beispielhaft ebenfalls 65° C betragen oder größer als dieser Wert sein. Da sich die thermische Gesamtbelastung des Leistungshalbleiterelements auch aus der Umgebungstemperatur ergibt, wird auch hierdurch in vorteilhafter Weise erreicht, dass thermische Gesamtbelastung des Leistungshalbleiterelements auch bei hohen Umgebungstemperaturen einen vorbestimmten Schwellwert nicht überschreitet.

In einer weiteren Ausführungsform wird der Sollwert des Leistungsstroms über ein Bussystem bereitgestellt, insbesondere über ein SPI-Bussystem. In diesem Fall kann der Sollwert von einem übergeordneten System bestimmt werden und über das Bussystem beispielsweise an die vorhergehend erläuterte Steuereinrichtung übertragen werden. Hierdurch ergibt sich in vorteilhafter Weise eine zuverlässige Bereitstellung der Steuergröße. Die Steuereinrichtung kann dann auswerten, ob der Sollwert größer als der vorbestimmte Schwellwert ist. Es ist auch vorstellbar, dass der Leistungsstrom gemessen und der aktuelle Ist-Wert mit dem vorbestimmten Schwellwert verglichen wird, wobei die Einstellung auf den Zielwert erfolgt, wenn der Ist-Wert größer als der vorbestimmte Schwellwert ist. In diesem Fall kann ein Stromsensor signaltechnisch über das Bussystem oder unmittelbar mit der Steuereinrichtung verbunden sein.

Alternativ oder kumulativ wird/werden die Halbleitertemperatur und/oder die Umgebungstemperatur durch einen Temperatursensor erfasst und/oder über ein Bussystem bereitgestellt. In diesem Fall kann der Temperatursensor signaltechnisch über das Bussystem oder unmittelbar mit der Steuereinrichtung verbunden sein. Auch hierdurch ergibt sich in vorteilhafter Weise eine zuverlässige Bereitstellung der Steuergröße. Der Temperatursensor kann ein Temperatursensor des Leistungshalbleiterelements sein, z.B. ein heiß- oder kaltleiterwiderstandbasierter Temperatursensor, wobei der Temperatursensor auf oder an dem Leistungshalbleiterelement angeordnet ist.

In einer bevorzugten Ausführungsform ist die Zeitdauer kleiner als oder gleich 20 Sekunden, vorzugsweise kleiner als oder gleich 10 Sekunden. Berechnungen haben gezeigt, dass hierdurch der Zielwert ausreichend häufig während der gesamten Lebensdauer des Leistungshalbleiterelements auf einen Wert außerhalb des Wertebereichs zwischen dem empfohlenen Minimalwert und empfohlenen Maximalwert eingestellt werden kann, ohne dass die Funktionsfähigkeit des Leistungshalbleiterelements beeinträchtigt wird. Somit ergibt sich in vorteilhafterweise eine hohe Betriebssicherheit bei gleichzeitiger Vergrößerung des Anwendungsbereichs.

In einer weiteren Ausführungsform wird eine Summe der Zeitdauern bestimmt, in denen die Steuergröße zur Einstellung des minimalen Durchgangswiderstands auf den Zielwert eingestellt wurde, wobei die Einstellung der Steuergröße zur Einstellung des minimalen Durchgangswiderstands auf den Zielwert nur dann durchgeführt wird, wenn die Summe kleiner als ein oder gleich einem vorbestimmten Schwellwert ist. Es ist beispielsweise möglich, dass die zu einem aktuellen Zeitpunkt gültige Summe als auch der vorbestimmte Schwellwert in einer Speichereinrichtung gespeichert ist und, z.B. durch die Steuereinrichtung, abgerufen wird. Ergibt die Prüfung, dass die Einstellung auf den Zielwert durchgeführt werden kann, so kann die aktuelle gespeicherte Summe um die vorbestimmte Zeitdauer inkrementiert und der resultierende Wert als aktualisierte Summe abgespeichert werden. Der vorbestimmte Schwellwert kann anwendungsabhängig gewählt werden und z.B. 100 Stunden oder mehr betragen. Er kann insbesondere derart gewählt werden, dass das Leistungshalbleiterelement während der Lebensdauer nicht länger als eine zulässige Zeitdauer mit Steuergrößen außerhalb des empfohlenen Wertebereichs betrieben wird. Hierdurch ergibt sich in vorteilhafter eine verbesserte Betriebssicherheit bei gleichzeitiger Vergrößerung des Anwendungsbereichs.

In einer weiteren Ausführungsform erfolgt die Einstellung der Steuergröße auf den Zielwert, wenn ein Fehler in einem Stromnetz detektiert wird, das das Leistungshalbleiterelement umfasst. Das Stromnetz kann insbesondere ein Traktionsnetz sein. In diesem Fall kann also z.B. ein Kurzschluss, der auch als sogenannter aktiver Kurzschluss (AKS) bezeichnet werden kann, über das Leistungshalbleiterelement hergestellt werden, da der Durchgangswiderstand minimiert wird. Ein solcher Kurzschluss-Zustand kann, insbesondere wenn das Leistungshalbleiterelement Bestandteil eines Stromrichters zum Betrieb einer elektrischen Maschine ist, ein gewünschter Zustand sein, da vermieden wird, dass die, insbesondere von der elektrischen Maschine, erzeugten Spannungen Komponenten im Stromnetz oder an das Stromnetz angeschlossene oder mit diesem verbundene Komponenten beschädigt werden, da die Spannungen aufgrund des Kurzschlusses abgebaut werden bzw. nicht auftreten. Ein Fehler im Stromnetz kann durch ein übergeordnetes System detektiert werden, welches dann ein entsprechendes Fehlersignal an die Steuereinrichtung übertragen kann, wobei diese bei Empfang des Fehlersignals die Einrichtung zur Bereitstellung der Steuergröße zur Einstellung des Zielwerts ansteuert. Ein Fehlerfall kann beispielsweise ein Kurzschluss im Stromnetz sein, insbesondere ein Kurzschluss in einem Wechselspannungs- und/oder Gleichspannungsabschnitt eines solchen Stromnetzes oder ein aktiver Kurzschluss, also ein von einem übergeordneten System eingestellter Kurzschluss. Somit ergibt sich in vorteilhafter Weise, dass eine Betriebssicherheit in einem Stromnetz erhöht wird.

In einer weiteren Ausführungsform erfolgt die Einstellung der Steuergröße auf den Zielwert, wenn ein vorbestimmter Betriebsmodus eines Fahrzeugs aktiviert wird, wobei das Leistungshalbleiterelement Bestandteil eines Traktionsnetzes des Fahrzeugs ist. Dieser Betriebsmodus kann beispielsweise ein Energiesparmodus oder Eco-Modus des Fahrzeugs sein. So kann beispielsweise von einem übergeordneten System ein Aktivierungssignal zur Einstellung der Steuergröße auf den Zielwert an die Steuereinrichtung übertragen werden. Der vorbestimmte Betriebsmodus kann z.B. durch eine Nutzereingabe oder automatisch aktiviert werden. Hierdurch lässt sich in vorteilhafter Weise eine Energieeffizienz weiter und somit auch eine Reichweite erhöhen, insbesondere da die Widerstandsverluste verringert werden. Es ist vorstellbar, dass die Einstellung der Steuergröße auf den Zielwert, wenn ein vorbestimmter Betriebsmodus eines Fahrzeugs aktiviert wird, unabhängig von der fest parametrisierten Zeitdauer erfolgt, z.B. so lange erfolgt bis der vorbestimmte Betriebsmodus wieder deaktiviert wird. Eine Reichweitenerhöhung wiederum führt zu einer besseren Akzeptanz von E-Mobilität und zu einem besseren Fahrgefühl für einen Fahrzeugführer.

Alternativ oder kumulativ erfolgt die Einstellung der Steuergröße auf den Zielwert, wenn ein Ladezustand einer Traktionsbatterie des Fahrzeugs kleiner als ein vorbestimmter Schwellwert ist, wobei das Leistungshalbleiterelement Bestandteil eines Traktionsnetzes des Fahrzeugs ist. Der Ladezustand (auch state of charge genannt) kann von einem übergeordneten System bestimmt werden. Dieses kann dann, wie vorhergehend erläutert, ein Aktivierungssignal zur Einstellung der Steuergröße auf den Zielwert an die Steuereinrichtung übertragen. Hierdurch ergibt sich in vorteilhafter Weise eine Reichweitenerhöhung, da die verbleibende gespeicherte Energie der Traktionsbatterie mit geringeren Widerstandsverlusten über das Leistungshalbleiterelement der elektrischen Maschine zugeführt werden kann. Es ist vorstellbar, dass die Einstellung der Steuergröße auf den Zielwert, wenn ein Ladezustand einer Traktionsbatterie des Fahrzeugs kleiner als ein vorbestimmter Schwellwert ist, unabhängig von der fest parametrisierten Zeitdauer erfolgt, z.B. so lange erfolgt wie der Ladezustand kleiner als der vorbestimmte Schwellwert ist.

In einer weiteren Ausführungsform erfolgt die Einstellung der Steuergröße auf den Zielwert, wenn eine Aktivierung durch Nutzereingabe erfolgt. Durch eine Nutzereingabe, insbesondere über eine geeignete Schnittstelle, die z.B. im Fahrzeug angeordnet sein kann, kann ein Aktivierungssignal erfolgen, welches dann an die Steuereinrichtung übertragen wird. Hierdurch ergibt sich in vorteilhafter Weise eine flexible Aktivierung der Einstellung der Steuergröße auf den Zielwert.

Alternativ kann die Einstellung erfolgen, wenn eine Aktivierung durch ein fahrzeugexternes System erfolgt. Ein entsprechendes Aktivierungssignal kann beispielsweise drahtlos an das Fahrzeug übertragen werden, z.B. im Rahmen einer Car2X- bzw. X2Car-Kommunikation. Es ist somit vorstellbar, dass ein Fahrzeugführer einen Kundenservice kontaktiert, falls z.B. eine Reichweitenverlängerung gewünscht ist, wobei der Kundenservice dann über ein geeignetes System ein Aktivierungssignal erzeugt und an das Fahrzeug überträgt. Die Kontaktierung des Kundenservice kann beispielsweise über eine geeignete Schnittstelle im Fahrzeug, z.B. ein HMI (human machine interface) erfolgen. Eine Reichweitenverlängerung kann beispielsweise gewünscht sein, wenn das Fahrzeug liegengeblieben ist. Hierdurch kann in vorteilhafter Weise eine hohe Betriebssicherheit des Fahrzeugs sichergestellt werden, insbesondere da das fahrzeugexterne System prüfen kann, ob durch eine Einstellung der Steuergröße auf den Zielwert eine Betriebsfähigkeit des Leistungshalbleiterelements in unerwünschter Weise beeinträchtigt werden kann, wobei keine Aktivierung erfolgt, wenn dies der Fall ist. Es ist weiter vorstellbar, dass die Möglichkeit zur Einstellung aktiviert werden muss, damit die Einstellung der Steuergröße auf den Zielwert ermöglicht wird. Diese Aktivierung kann beispielsweise durch ein übergeordnetes System, insbesondere ein fahrzeugexternes System, erfolgen. Z.B. kann ein Fahrzeugeigentümer die Aktivierung beantragen, wobei die Aktivierung beispielsweise kostenpflichtig sein kann. Es ist vorstellbar, dass die Einstellung der Steuergröße auf den Zielwert, wenn eine Aktivierung durch Nutzereingabe und/oder durch ein fahrzeugexternes System erfolgt, unabhängig von der fest parametrisierten Zeitdauer erfolgt, z.B. so lange erfolgt bis eine entsprechende Deaktivierung erfolgt.

In einer weiteren Ausführungsform erfolgt die Einstellung auf den Zielwert, indem einer Einrichtung zur Bereitstellung der Steuergröße der Zielwert als Sollwert übermittelt wird. In diesem Fall kann also die Einrichtung, die auch die Steuergröße mit dem empfohlenen Wert zur Einstellung des minimalen Durchgangswiderstands bereitstellt, angesteuert werden, um die Steuergröße mit dem Zielwert bereitzustellen. Dies kann durch eine geeignete Steuer- oder Regelstrategie erfolgen. Hierdurch ergibt sich in vorteilhafter Weise eine einfach zu realisierende Einstellung auf den Zielwert, insbesondere ohne einen Bedarf an weiteren Komponenten.

Alternativ kann der Einrichtung zur Bereitstellung der Steuergröße der empfohlene Wert zur Einstellung des minimalen Durchgangswiderstands als Sollwert übermittelt werden, wobei eine Einrichtung zur Bereitstellung einer Zusatzsteuergröße eine Zusatzgröße bereitstellt, die der Differenz zwischen dem Zielwert und dem von der Einrichtung zur Erzeugung der Steuergröße bereitgestellten Ausgangswert bzw. dem empfohlenen Wert entspricht. Hierdurch ergibt sich in vorteilhafter Weise, dass die entsprechende Funktionalität in einfacher Weise nachgerüstet werden kann, insbesondere wenn die Einrichtung zur Bereitstellung der Steuergröße nicht zur Bereitstellung des Zielwerts ausgelegt ist.

Die Einrichtung zur Bereitstellung einer Zusatzgröße kann insbesondere eine hardwaretechnisch zur Einrichtung zur Bereitstellung der Steuergröße separat ausgebildete Einrichtung sein. Es ist auch möglich, insbesondere wenn ein Fehlerfall wie z.B. ein Kurzschluss oder aktiver Kurzschluss oder ein Ausfall oder eine Nichterreichbarkeit der Einrichtung der Bereitstellung der Steuergröße detektiert wird, dass die Einrichtung zur Bereitstellung einer Zusatzsteuergröße derart betrieben wird, dass diese den Zielwert oder den empfohlenen Wert (und somit nicht nur eine Zusatzgröße) bereitstellt.

Weiter vorgeschlagen wird eine Vorrichtung zum Betrieb eines Leistungshalbleiterelements mit einem einstellbaren Durchgangswiderstand für einen Leistungsstrom, wobei die Vorrichtung mindestens eine Einrichtung zur Bereitstellung einer Steuergröße zur Einstellung des Durchgangswiderstands umfasst. Diese Einrichtung kann z.B. eine Treiberschaltung sein, insbesondere eine Gate-Treiberschaltung. Auch kann die Vorrichtung die vorhergehend bereits erläuterte Einrichtung zur Bereitstellung einer Zusatzsteuergröße umfassen und derart ausgebildet sein, dass die Steuergröße und die Zusatzsteuergröße sich additiv zur Bereitstellung einer resultierenden Steuergröße überlagern.

Weiter wird die Steuergröße zur Einstellung des minimalen Durchgangswiderstands verändert, wobei die Steuergröße zur Einstellung des minimalen Durchgangswiderstands für eine vorbestimmte Zeitdauer auf einen Zielwert eingestellt wird, der von einem empfohlenen Wert zur Einstellung eines empfohlenen minimalen Durchgangswiderstands abweicht und zu einer Verringerung des minimalen Durchgangswiderstands im Vergleich zu dem empfohlenen Durchgangswiderstand führt.

Erfindungsgemäß wird die Steuergröße für eine vorbestimmte Zeitdauer auf den Zielwert eingestellt, wobei die vorbestimmte Zeitdauer fest parametrisiert ist.

Die Vorrichtung kann die vorhergehend erläuterte Steuereinrichtung umfassen, die einen Betrieb der Einrichtung zur Bereitstellung der Steuergröße und gegebenenfalls auch einen Betrieb der Einrichtung zur Bereitstellung einer Zusatzsteuergröße steuert. Weiter kann die Vorrichtung eine Speichereinrichtung umfassen, z.B. für den Wert der fest parametrisierten Zeitdauer. Die Speichereinrichtung kann auch zur Speicherung der vorhergehend erläuterten Summe dienen. Weiter kann die Vorrichtung mindestens eine Schnittstelle umfassen, z.B. zum Empfang eines Sollwerts, eines Temperaturwerts, eines Aktivierungssignals bzw. zur datentechnischen Verbindung mit einem übergeordneten System, das insbesondere ein fahrzeuginternes aber auch ein fahrzeugexternes System sein kann. Die Vorrichtung kann auch das Leistungshalbleiterelement umfassen.

Die Vorrichtung kann hierbei derart konfiguriert sein, dass ein Verfahren mit den erläuterten Vorteilen gemäß einer der in dieser Offenbarung beschriebenen Ausführungsformen mit der Vorrichtung ausführbar ist. Somit ist also das Verfahren mit einer Vorrichtung, die gemäß einer der in dieser Offenbarung beschriebenen Ausführungsformen ausgebildet ist, ausführbar.

Die Erfindung wird anhand von Ausführungsbeispielen näher erläutert. Die Figuren zeigen:
- Fig. 1: ein schematisches Flussdiagramm eines erfindungsgemäßen Verfahren,
- Fig. 2: ein schematisches Flussdiagramm eines erfindungsgemäßen Verfahren in einer weiteren Ausführungsform,
- Fig. 3: einen schematischen zeitlichen Verlauf einer Steuergröße,
- Fig. 4: ein schematisches Blockschaltbild einer erfindungsgemäßen Vorrichtung und
- Fig. 5: ein schematisches Blockschaltbild einer erfindungsgemäßen Vorrichtung in einer weiteren Ausführungsform.

Nachfolgend bezeichnen gleiche Bezugszeichen Elemente mit gleichen oder ähnlichen technischen Eigenschaften.

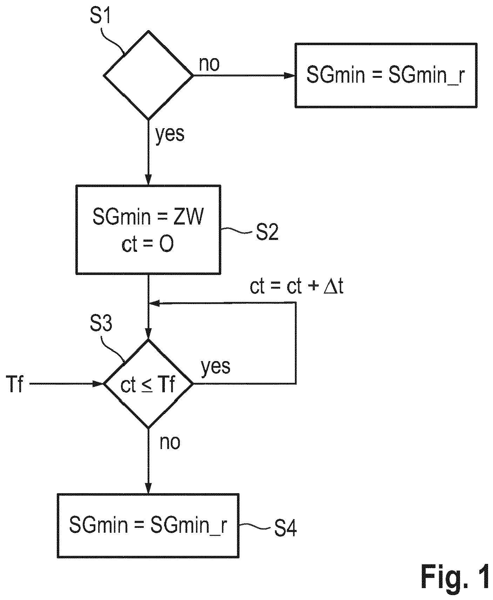

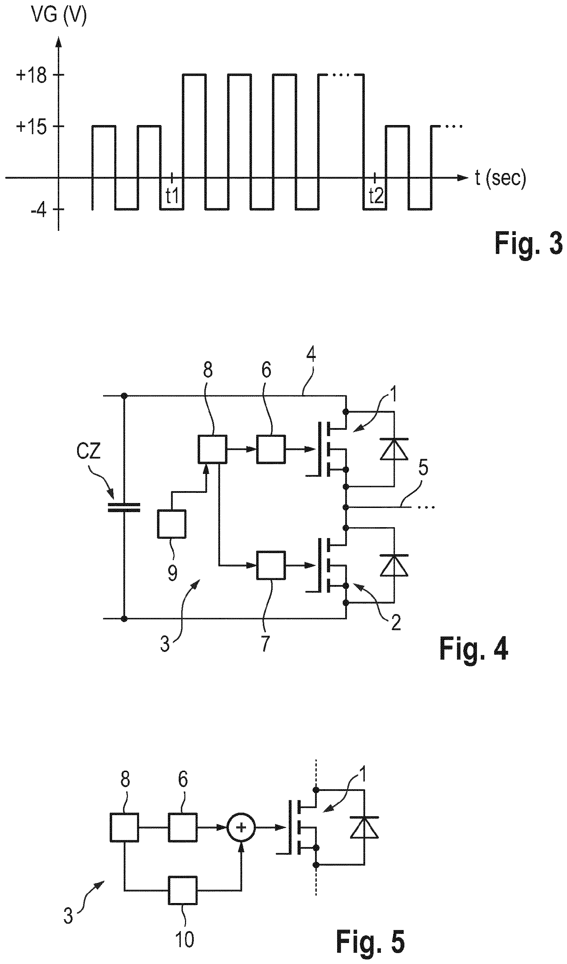

Fig. 1 zeigt ein schematisches Flussdiagramm eines erfindungsgemäßen Verfahrens. In einem ersten Schritt S1 wird geprüft, ob eine Steuergröße SGmin zur Einstellung des minimalen Durchgangswiderstands, beispielsweise eine Gate-Spannung VG (siehe Fig. 3), eines Leistungshalbleiterelements, beispielsweise eines MOSFET 1, 2 (siehe Fig. 4) auf einen Zielwert ZW eingestellt werden soll, der von einem empfohlenen Wert SGmin_r zur Einstellung eines minimalen Durchgangswiderstands abweicht und zu einer Verringerung des minimalen Durchgangswiderstands im Vergleich zu dem Durchgangswiderstand führt, der sich bei einer Einstellung der Steuergröße SGmin auf den empfohlenen Wert SGmin_r einstellt. Hierzu kann genau ein oder können mehrere Kriterien aus einer Menge von Kriterien ausgewertet werden, die nachfolgend noch näher erläutert werden. Ist das/Sind die Kriterien erfüllt, so wird die Steuergröße SGmin in einem zweiten Schritt S2 auf den Zielwert eingestellt und ein Zeitzählerwert auf den Wert ct gleich Null gesetzt. Die Steuergröße SGmin wird hierbei für eine vorbestimmte Zeitdauer auf den Zielwert ZW eingestellt, wobei die vorbestimmte Zeitdauer fest parametrisiert ist. So wird wiederholt, insbesondere periodisch, in einem dritten Schritt S3 geprüft, ob die Zeitdauer mit eingestelltem Zielwert ZW kleiner als ein vorbestimmter und fest parametrisierter Schwellwert Tf oder gleich diesem Schwellwert Tf ist. Somit entspricht der Schwellwert Tf der vorbestimmten Zeitdauer. Ist das nicht der Fall, so wird die Zeitzählerwert ct um ein Zeitinkrement Δt inkrementiert und der dritte Schritt S3 erneut durchgeführt. Sobald der Zeitzählwert ct größer als der vorbestimmte Schwellwert Tf ist, wird die Steuergröße SGmin in einem vierten Schritt S4 wieder auf den empfohlenen Wert SGmin_r gesetzt. Der vorbestimmte Schwellwert Tf kann hierbei in einer Speichereinrichtung 9 (siehe Fig. 4) abgespeichert sein und zur Auswertung aus dieser abgerufen werden.

Ist mindestens ein Kriterium, welches im ersten Schritt S1 geprüft wird, nicht erfüllt, so wird die Steuergröße SGmin auf den empfohlenen Wert SGmin_r gesetzt.

Ein Kriterium, welches im ersten Schritt S1 geprüft wird, kann erfüllt sein, wenn ein Sollwert des Leistungsstroms durch das Leistungshalbleiterelement größer als ein vorbestimmter Schwellwert ist. Ein weiteres Kriterium kann erfüllt sein, wenn eine Halbleitertemperatur größer als ein vorbestimmter Schwellwert ist. Ein weiteres Kriterium kann erfüllt sein, wenn eine Umgebungstemperatur größer als ein vorbestimmter Schwellwert ist.

Ein weiteres Kriterium kann erfüllt sein, wenn ein Fehler in einem Stromnetz detektiert wird, das das Leistungshalbleiterelement umfasst oder wenn ein vorbestimmter Betriebsmodus eines Fahrzeugs aktiviert wird und/oder wenn ein Ladezustand einer Traktionsbatterie des Fahrzeugs kleiner als ein vorbestimmter Schwellwert ist, wobei das Leistungshalbleiterelement Bestandteil eines Traktionsnetzes des Fahrzeugs ist.

Es ist auch möglich, dass die Einstellung der Steuergröße auf den Zielwert ZW erfolgt, wenn eine Aktivierung durch Nutzereingabe und/oder durch ein fahrzeugexternes System erfolgt, wobei auch in diesem Fall ein entsprechendes Kriterium erfüllt sein kann.

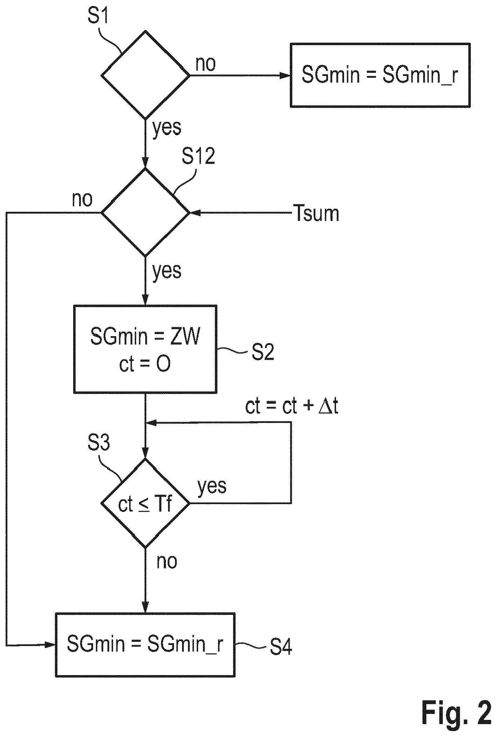

Fig. 2 zeigt ein schematisches Flussdiagramm eines erfindungsgemäßen Verfahrens in einer weiteren Ausführungsform. Im Unterschied zu der in Fig. 1 dargestellten Ausführungsform wird in einem Zwischenschritt S12 zwischen dem ersten und dem zweiten Schritt S1, S2 die Summe der Zeitdauern bestimmt, in denen die Steuergröße SGmin zur Verringerung des Durchgangswiderstands bereits auf den Zielwert ZW eingestellt war. Ist diese Summe kleiner als ein weiterer vorbestimmter Schwellwert Tsum oder gleich diesem Schwellwert Tsum, so wird das Verfahren mit dem in Fig. 1 dargestellten dritten Schritt S3 fortgeführt. Ist jedoch die Summe größer als der vorbestimmte Schwellwert Tsum, so wird die Steuergröße SGmin auf den empfohlenen Wert SGmin_r gesetzt und es erfolgt keine Einstellung des Steuergröße SGmin auf den Zielwert ZW.

Fig. 3 zeigt einen schematischen zeitlichen Verlauf einer Steuergröße, nämlich eine Gatespannung VG eines MOSFET 1, 2 (siehe Fig. 4). Der MOSFET 1, 2 kann z.B. Bestandteil eines Stromrichters sein, der wiederum eine Wechselspannung zum Betrieb einer elektrischen Maschine, beispielsweise einer Traktionsmaschine in einem Elektro- oder Hybridfahrzeug, bereitstellen kann. Hierzu kann der MOSFET 1, 2 getaktet betrieben werden, wobei die Gatespannung VG mit einem Tastverhältnis, welches von einem übergeordneten System bestimmt werden kann, zwischen einem Wert zur Einstellung eines minimalen Durchgangswiderstands und einem Wert zur Einstellung eines maximalen Durchgangswiderstands betrieben wird. In Fig. 3 ist dargestellt, dass ein empfohlener Wert der Steuergröße SGmin_r zur Einstellung eines minimalen Durchgangswiderstands, also des empfohlenen minimalen Durchgangswiderstands, +15 V beträgt. Ein empfohlener Wert zur Einstellung eines maximalen Durchgangswiderstands beträgt -4 V.

Zu einem ersten Zeitpunkt t1 wird detektiert, beispielsweise da das in einem ersten Schritt S1 (siehe Fig. 1 oder Fig. 2) geprüfte Kriterium erfüllt ist, dass die Steuergröße SGmin zur Einstellung eines minimalen Durchgangswiderstands auf einen Zielwert ZW eingestellt werden soll, womit der minimale Durchgangswiderstand im Vergleich zur dem Durchgangswiderstand bei eingestellter empfohlener Steuergröße SGmin_r weiter verringert wird. Der Zielwert ZW beträgt z.B. +18 V. Weiter ist dargestellt, dass diese Steuergröße SGmin bis zu einem zweiten Zeitpunkt t2 auf den Zielwert ZW eingestellt bleibt, wobei Zeitdifferenz zwischen dem zweiten und dem ersten Zeitpunkt t2, t1 dem vorbestimmten Schwellwert Tf, der beispielsweise 10 oder 20 Sekunden betragen kann, entspricht.

Fig. 4 zeigt ein schematisches Blockschaltbild einer erfindungsgemäßen Vorrichtung 3. Die Vorrichtung 3 dient zum Betrieb eines Leistungshalbleiterelements mit einem einstellbaren Durchgangswiderstand für einen Leistungsstrom, z.B. zum Betrieb eines MOSFET 1, 2. Das Leistungshalbleiterelement kann Teil eines Stromnetzes sein, welches z.B. ein Traktionsnetz eines Elektro- oder Hybridfahrzeugs sein kann. Das Stromnetz kann einen Zwischenkreiskondensator CZ umfassen. Ein erster MOSFET 1 kann ein so genannter High-Side-MOSEFT und ein zweiter MOSFET 2 kann ein so genannter Low-Side-MOSFET einer Halbbrücke eines Stromrichters sein, wobei die MOSFETs 1, 2 derart betrieben werden, dass eine Gleichspannung in einem Zwischenkreis 4 in eine Wechselspannung einer Phasenleitung 5 umgewandelt wird. Die Vorrichtung 3 umfasst eine erste Einrichtung 6 zur Bereitstellung einer Steuergröße zur Einstellung des Durchgangswiderstands des ersten MOSFET 1 und eine zweite Einrichtung 7 zur Einstellung des Durchgangswiderstands des zweiten MOSFET 2. Solche Einrichtungen 6, 7 sind dem Fachmann bekannt und können elektrische oder elektronische Bauteile zur Bereitstellung einer z.B. als Gatespannung VG ausgebildeten Steuergröße umfassen. Weiter umfasst die Vorrichtung 3 einen Steuereinrichtung 8, die z.B. als Mikrocontroller oder integrierte Schaltung ausgebildet ist oder eine(n) solche(n) umfassen kann. Diese Steuereinrichtung steuert die Einrichtungen 6, 7 derart an, dass diese einen gewünschten zeitlichen Verlauf der Steuergröße bereitstellen.

Nicht in Fig. 4 dargestellt ist eine Energieversorgungseinrichtung zur Versorgung der Einrichtungen 6, 7, wobei diese aus der von der Energieversorgungseinrichtung, beispielsweise einem Kondensator oder einer davon verschiedenen Energiespeichereinrichtung, die gewünschte Steuergröße bereitstellt. Insbesondere kann die Auswerteeinrichtung 8 das Kriterium/die Kriterien auswerten, die im ersten Schritt S1 des in Fig. 1 dargestellten Verfahrens ausgewertet werden. Ist das/Sind die Kriterien erfüllt, so kann die Steuereinrichtung 8 die erste Einrichtung 6, die zweite Einrichtung 7 oder aber beide Einrichtungen 6, 7 derart ansteuern, dass als Steuergröße SGmin zur Einstellung des minimalen Durchgangswiderstands für eine vorbestimmte Zeitdauer ein Zielwert ZW (siehe z.B. Fig. 1) eingestellt wird, wobei dieser - wie bereits erläutert - von einem empfohlenen Wert SGmin_r zur Einstellung eines empfohlenen minimalen Durchgangswiderstands abweicht. Hierzu kann die Steuereinrichtung 8 insbesondere einen Sollwert für die von der Einrichtung 6, 7 bereitgestellte Steuergröße, die eine Ausgangsgröße dieser Einrichtung 6, 7 ist, verändern, z.B. von einem Wert von +15V auf den Wert +18V. Die vorbestimmte Zeitdauer ist fest parametrisiert und in einer Speichereinrichtung 9 der Vorrichtung 3 gespeichert und wird aus dieser zur Laufzeit abgerufen.

Fig. 5 zeigt ein schematisches Blockschaltbild einer erfindungsgemäßen Vorrichtung 3 in einer weiteren Ausführungsform. Im Unterschied zu der in Fig. 4 dargestellten Ausführungsform umfasst die Vorrichtung 3 eine Einrichtung 10 zur Bereitstellung einer Zusatzsteuergröße. Ist das/Sind die Kriterien, das/die im ersten Schritt S1 (siehe Fig. 1) geprüft wird/werden, erfüllt, so kann die Steuereinrichtung 8 die erste Einrichtung 6 derart ansteuern, dass diese den empfohlenen Wert SGmin_r zur Einstellung eines minimalen Durchgangswiderstands bereitstellt. Weiter kann die Steuereinrichtung 8 die Einrichtung 10 zur Bereitstellung einer Zusatzsteuergröße derart ansteuern, dass diese die Differenz zwischen dem Zielwert ZW und dem von der Einrichtung 6 zur Erzeugung der Steuergröße bereitgestellten Ausgangswert oder dem empfohlenen Wert SGmin_r bereitstellt. Beträgt der Zielwert ZW beispielsweise +18V und die empfohlene Steuergröße SGmin_r zur Einstellung eines minimalen Durchgangswiderstands beispielsweise +15V, so kann die Steuereinrichtung 8 die Einrichtung 10 zur Bereitstellung einer Zusatzsteuergröße derart ansteuern, dass diese eine Zusatzspannung von +3V erzeugt. Die von der Einrichtung 10 zur Bereitstellung einer Zusatzsteuergröße bereitgestellte Ausgangsgröße kann dann der Ausgangsgröße additiv überlagert werden, die von der ersten Einrichtung 6 bereitgestellt wird

## Patentansprüche

1. Verfahren zum Betrieb eines Leistungshalbleiterelements mit einem einstellbaren Durchgangswiderstand für einen Leistungsstrom, wobei eine Steuergröße (SGmin) zur Einstellung des minimalen Durchgangswiderstands verändert wird, wobei die Steuergröße (SGmin) zur Einstellung des minimalen Durchgangswiderstands für eine vorbestimmte Zeitdauer auf einen Zielwert (ZW) eingestellt wird, der von einem empfohlenen Wert (SGmin_r) zur Einstellung eines empfohlenen minimalen Durchgangswiderstands abweicht und zu einer Verringerung des minimalen Durchgangswiderstands im Vergleich zu dem empfohlenen Durchgangswiderstand führt,
**dadurch gekennzeichnet, dass**
die Steuergröße (SGmin) für eine vorbestimmte Zeitdauer (Tf) auf den Zielwert (ZW) eingestellt wird, wobei die vorbestimmte Zeitdauer (Tf) fest parametrisiert ist.

2. Verfahren nach Anspruch 1, **dadurch gekennzeichnet, dass** die Einstellung der Steuergröße (SGmin) auf den Zielwert (ZW) erfolgt, wenn ein Sollwert des Leistungsstroms größer als ein vorbestimmter Schwellwert ist und/oder eine Halbleitertemperatur größer als ein vorbestimmter Schwellwert ist und/oder eine Umgebungstemperatur größer als ein vorbestimmter Schwellwert ist.

3. Verfahren nach Anspruch 2, **dadurch gekennzeichnet, dass** der Sollwert über ein Bussystem bereitgestellt wird und/oder die Halbleitertemperatur und/oder die Umgebungstemperatur durch einen Temperatursensor erfasst und/oder über ein Bussystem bereitgestellt wird.

4. Verfahren nach einem der vorangegangenen Ansprüche, **dadurch gekennzeichnet, dass** die Zeitdauer kleiner als oder gleich 20 Sekunden ist.

5. Verfahren nach einem der vorangegangenen Ansprüche, **dadurch gekennzeichnet, dass** eine Summe der Zeitdauern bestimmt wird, in denen die Steuergröße (SGmin) zur Verringerung des Durchgangswiderstands auf den Zielwert (ZW) eingestellt wurde, wobei die Einstellung der Steuergröße (SGmin) zur Einstellung des minimalen Durchgangswiderstands auf den Zielwert (ZW) nur dann durchgeführt wird, wenn die Summe kleiner als ein oder gleich einem vorbestimmten Schwellwert (Tsum) ist.

6. Verfahren nach einem der vorangegangenen Ansprüche, **dadurch gekennzeichnet, dass** die Einstellung der Steuergröße (SGmin) auf den Zielwert (ZW) erfolgt, wenn ein Fehler in einem Stromnetz detektiert wird, das das Leistungshalbleiterelement umfasst.

7. Verfahren nach einem der vorangegangenen Ansprüche, **dadurch gekennzeichnet, dass** die Einstellung der Steuergröße (SGmin) auf den Zielwert (ZW) erfolgt, wenn ein vorbestimmter Betriebsmodus eines Fahrzeugs aktiviert wird und/oder wenn ein Ladezustand einer Traktionsbatterie des Fahrzeugs kleiner als ein vorbestimmter Schwellwert ist, wobei das Leistungshalbleiterelement Bestandteil eines Traktionsnetzes des Fahrzeugs ist.

8. Verfahren nach einem der vorangegangenen Ansprüche, **dadurch gekennzeichnet, dass** die Einstellung der Steuergröße (SGmin) auf den Zielwert (ZW) erfolgt, wenn eine Aktivierung durch Nutzereingabe und/oder durch ein fahrzeugexternes System erfolgt.

9. Verfahren nach einem der vorangegangenen Ansprüche, **dadurch gekennzeichnet, dass** die Einstellung auf den Zielwert (ZW) erfolgt, indem einer Einrichtung (6) zur Bereitstellung der Steuergröße der Zielwert (ZW) als Sollwert übermittelt wird oder indem der Einrichtung (6) zur Bereitstellung der Steuergröße der empfohlene Wert (SGmin_r) zur Einstellung des minimalen Durchgangswiderstands als Sollwert übermittelt wird, wobei eine Einrichtung (10) zur Bereitstellung einer Zusatzsteuergröße eine Zusatzgröße bereitstellt, die der Differenz zwischen dem Zielwert (ZW) und dem von der Einrichtung zur Erzeugung der Steuergröße bereitgestellten Ausgangswert oder dem empfohlenen Wert (SGmin_r) entspricht.

10. Vorrichtung zum Betrieb eines Leistungshalbleiterelements mit einem einstellbaren Durchgangswiderstand für einen Leistungsstrom, wobei die Vorrichtung (3) mindestens eine Einrichtung (6, 7) zur Bereitstellung einer Steuergröße zur Einstellung des Durchgangswiderstands umfasst, wobei die Steuergröße (SGmin) zur Einstellung des minimalen Durchgangswiderstands verändert wird, wobei die Steuergröße (SGmin) zur Einstellung des minimalen Durchgangswiderstands für eine vorbestimmte Zeitdauer (Tf) auf einen Zielwert (ZW) eingestellt wird, der von einem empfohlenen Wert (SGmin_r) zur Einstellung eines empfohlenen minimalen Durchgangswiderstands abweicht und zu einer Verringerung des minimalen Durchgangswiderstands im Vergleich zu dem empfohlenen Durchgangswiderstand führt,
**dadurch gekennzeichnet, dass**
die Steuergröße (SGmin) für eine vorbestimmte Zeitdauer (Tf) auf den Zielwert (ZW) eingestellt wird, wobei die vorbestimmte Zeitdauer (Tf) fest parametrisiert ist.
